# EUROPEAN PATENT APPLICATION

(11) **EP 4 848 586 A1**
(43) Date of publication of application: **02.12.2026**
(21) Application number: 25757701.5
(22) Date of filing: 18.02.2025
(51) Int. Cl.: H03H 9/64

(54) **ELASTIC WAVE DEVICE, CIRCUIT AND ELECTRONIC APPARATUS**

(30) Priority: 22.02.2024 CN 202410201561
(71) Applicant: Huawei Technologies Co., Ltd., Shenzhen, Guangdong 518129 (CN)
(72) Inventor: OIKAWA, Rei, Shenzhen, Guangdong 518129 (CN); NISHIMURA, Kazunori, Shenzhen, Guangdong 518129 (CN)
(74) Representative: Goddar, Heinz J.
(86) International application number: PCT/CN2025/077806
(87) International publication number: WO 2025/176109

(57) **Abstract**

This application provides an elastic wave device, a circuit, and an electronic device. The elastic wave apparatus includes an electrode and two piezoelectric layers. The two piezoelectric layers may be respectively referred to as a first piezoelectric layer and a second piezoelectric layer. The electrode is disposed on the first piezoelectric layer, and the first piezoelectric layer is disposed above the first piezoelectric layer. The electrode is configured to generate an elastic wave with a wavelength λ. An Euler angle of the first piezoelectric layer is different from an Euler angle of the second piezoelectric layer. A material of the first piezoelectric layer is the same as a material of the second piezoelectric layer, and the material of the first piezoelectric layer and the material of the second piezoelectric layer are lithium tantalate or lithium niobate. The two piezoelectric layers having different Euler angles can suppress or reduce unnecessary high-order mode responses, allowing the elastic wave apparatus to have good electrical characteristics in a main vibration mode.

## Description

This application claims priority to Chinese Patent Application No. 202410201561.1, filed with the China National Intellectual Property Administration on February 22, 2024 and entitled "ELASTIC WAVE DEVICE, CIRCUIT, AND ELECTRONIC DEVICE", which is incorporated herein by reference in its entirety.

### TECHNICAL FIELD

This application relates to the field of electronic technologies, and more specifically, to an elastic wave device, a circuit, and an electronic device.

### BACKGROUND

Elastic wave apparatuses are widely used in components such as resonators and filters. For example, a surface acoustic wave (surface acoustic wave, SAW) filter is a common elastic wave apparatus. The SAW filter is a dedicated filtering device made of piezoelectric materials such as quartz crystals or piezoelectric ceramics, utilizing the piezoelectric effect and the physical characteristics of surface acoustic wave propagation. The SAW is widely used in the mobile communication field. For example, a filter in a radio frequency circuit of a mobile terminal may include a SAW filter.

### SUMMARY

This application provides an elastic wave device, a circuit, and an electronic device. The elastic wave device provided in embodiments of this application has good electrical characteristics in a main vibration mode.

According to a first aspect, an embodiment of this application provides an elastic wave apparatus. The elastic wave apparatus includes an electrode and two piezoelectric layers. The two piezoelectric layers may be respectively referred to as a first piezoelectric layer and a second piezoelectric layer. The electrode is disposed on the first piezoelectric layer, and the first piezoelectric layer is disposed above the first piezoelectric layer. The electrode is configured to generate an elastic wave with a wavelength λ. An Euler angle of the first piezoelectric layer is different from an Euler angle of the second piezoelectric layer. A material of the first piezoelectric layer is the same as a material of the second piezoelectric layer, and the material of the first piezoelectric layer and the material of the second piezoelectric layer are lithium tantalate or lithium niobate.

The two piezoelectric layers having different Euler angles can suppress or reduce unnecessary high-order mode responses, allowing the elastic wave apparatus to have good electrical characteristics in a main vibration mode.

With reference to the first aspect, in a possible implementation of the first aspect, a thickness of the first piezoelectric layer is less than a thickness of the second piezoelectric layer.

With reference to the first aspect, in a possible implementation of the first aspect, a ratio of the thickness of the first piezoelectric layer to the thickness of the second piezoelectric layer is 1:2.

With reference to the first aspect, in a possible implementation of the first aspect, a sum of the thickness of the first piezoelectric layer and the thickness of the second piezoelectric layer is less than or equal to 0.4λ.

With reference to the first aspect, in a possible implementation of the first aspect, the Euler angle of the first piezoelectric layer is (φ, θ, ψ), and the Euler angle of the second piezoelectric layer is (φ, θ+180±60, ψ+180±5).

The thickness and/or the Euler angle of the first piezoelectric layer and the thickness and/or the Euler angle the second piezoelectric layer are adjusted, electrical characteristics of the elastic wave apparatus can be further improved.

With reference to the first aspect, in a possible implementation of the first aspect, a sign of a piezoelectric constant tensor of the first piezoelectric layer is different from a sign of a piezoelectric constant tensor of the second piezoelectric layer.

With reference to the first aspect, in a possible implementation of the first aspect, a thickness of the electrode is greater than or equal to 0.03λ and less than or equal to 0.12λ.

With reference to the first aspect, in a possible implementation of the first aspect, the elastic wave apparatus further includes a support substrate located below the second piezoelectric layer, where an elastic wave velocity of the support substrate is greater than an elastic wave velocity of the first piezoelectric layer and an elastic wave velocity of the second piezoelectric layer.

The support substrate is made of a high-speed material, so that electrical performance of the elastic wave apparatus can be further improved.

With reference to the first aspect, in a possible implementation of the first aspect, the elastic wave apparatus further includes a temperature compensation layer, where the temperature compensation layer is located between the second piezoelectric layer and the support substrate, and a sign of a temperature coefficient of the temperature compensation layer is opposite to a sign of a temperature coefficient of the first piezoelectric layer and a sign of a temperature coefficient of the second piezoelectric layer.

In the foregoing technical solution, the temperature compensation layer is introduced, so that a frequency deviation caused by a temperature change can be reduced.

With reference to the first aspect, in a possible implementation of the first aspect, an elastic wave velocity of the temperature compensation layer is less than the elastic wave velocity of the first piezoelectric layer and the elastic wave velocity of the second piezoelectric layer.

The temperature compensation layer is made of a low-speed material, so that electrical performance of the elastic wave apparatus can be further improved.

With reference to the first aspect, in a possible implementation of the first aspect, the elastic wave further includes an intermediate dielectric layer, where the intermediate dielectric layer is located between the temperature compensation layer and the support substrate.

According to a second aspect, an embodiment of this application provides a circuit. The circuit includes one or more elastic wave apparatuses according to the first aspect or any one of the possible implementations of the first aspect.

According to a third aspect, an embodiment of this application provides an electronic device. The electronic device includes the circuit according to the second aspect.

### BRIEF DESCRIPTION OF DRAWINGS

FIG. 1 is a diagram of a structure of an electronic device 100;
FIG. 2 is a diagram of a structure of an elastic wave apparatus according to an embodiment of this application;
FIG. 3 is a diagram of a conventional elastic wave apparatus;
FIG. 4 shows characteristic curves of an elastic wave apparatus according to an embodiment of this application and a conventional elastic wave apparatus;
FIG. 5 shows another elastic wave apparatus according to an embodiment of this application;
FIG. 6 is a diagram of a conventional elastic wave apparatus;
FIG. 7 shows characteristic curves of an elastic wave apparatus according to an embodiment of this application and a conventional elastic wave apparatus;
FIG. 8 shows still another elastic wave apparatus according to an embodiment of this application;
FIG. 9 is a diagram of a conventional elastic wave apparatus;
FIG. 10 shows characteristic curves of an elastic wave apparatus according to an embodiment of this application and a conventional elastic wave apparatus;
FIG. 11 is a diagram of an electrode of a SAW filter; and
FIG. 12 is a diagram of an electrode finger period.

### DESCRIPTION OF EMBODIMENTS

The following describes technical solutions of this application with reference to accompanying drawings. It may be understood that the accompanying drawings in embodiments of this application are merely diagrams drawn to help a person skilled in the art better understand a structure of an elastic wave apparatus. Size and thickness proportions of elements in the figures do not necessarily reflect actual size ratios.

In embodiments of this application, the term "example", "for example", or the like are used to indicate an example, an illustration, or a description. Any embodiment or design scheme described as an "example" in this application should not be construed as being more preferred or having more advantages than other embodiments or design schemes. Specifically, the term "example" is intended to present a concept in a specific manner.

In embodiments of this application, "relevant (corresponding, relevant)" and "corresponding (corresponding)" may sometimes be used interchangeably. It should be noted that, when differences between the terms are not emphasized, the meanings intended to be expressed by the terms are consistent.

A network architecture and a service scenario described in embodiments of this application are intended to describe the technical solutions in embodiments of this application more clearly, and do not constitute a limitation on the technical solutions provided in embodiments of this application. A person of ordinary skill in the art may know that, with evolution of the network architecture and emergence of new service scenarios, the technical solutions provided in embodiments of this application are also applicable to similar technical problems.

Reference to "an embodiment", "some embodiments", or the like described in the specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean referring to "one or more but not all of embodiments", unless otherwise specifically emphasized in another manner. The terms "include", "contain", "have", and their variants all mean "include but are not limited to", unless otherwise specifically emphasized in another manner.

In this application, "at least one" means one or more, and "a plurality of" means two or more. "And/or" describes an association relationship between associated objects, and indicates that three relationships may exist. For example, A and/or B may indicate the following three cases: Only A exists, both A and B exist, and only B exists, where A and B may be singular or plural. The character "/" generally indicates an "or" relationship between associated objects. "At least one of the following items (pieces)" or a similar expression thereof means any combination of these items, including a singular item (piece) or any combination of plural items (pieces). For example, at least one item (piece) of a, b, or c may indicate a, b, c, a and b, a and c, b and c, or a, b, and c, where a, b, and c may be singular or plural.

It may be understood that the following descriptions are merely embodiments and are not intended to be limiting. For example, in the following descriptions, disposing a second component above or on a first component may include an embodiment in which the first component and the second component are in direct contact with each other, may include an embodiment in which the first component is in contact with the second component through an adhesive, or may include an embodiment in which an additional component is disposed between the first component and the second component, so that the first component and the second component are not in direct contact with each other.

The elastic wave apparatus in embodiments of this application may be a filter (for example, a SAW filter or a bulk acoustic wave (bulk acoustic wave, BAW) filter), a resonator (for example, a SAW resonator or a BAW resonator), a duplexer, or the like.

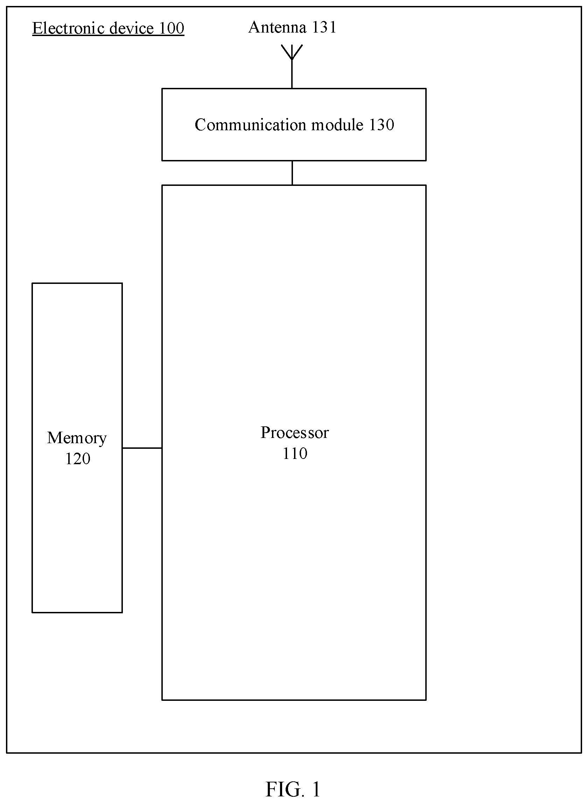

For example, FIG. 1 is a diagram of a structure of an electronic device 100. The electronic device 100 may include a processor 110, a memory 120, a communication module 130, and an antenna 131.

It may be understood that the structure shown in this embodiment of this application does not constitute a specific limitation on the electronic device 100. In some other embodiments of this application, the electronic device 100 may include more or fewer components than those shown in the figure, some components may be combined, some components may be split, or different component arrangements may be used. The components shown in the figure may be implemented by hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a memory, a video codec, a digital signal processor (digital signal processor, DSP), a baseband processor, a neural-network processing unit (neural-network processing unit, NPU), and/or the like. Different processing units may be independent components, or may be integrated into one or more processors.

The memory 120 may be configured to store computer-executable program code. The executable program code includes instructions. The processor 110 runs the instructions stored in the memory 120, to execute various functional applications of the electronic device 100 and process data. The memory 120 may include a program storage area and a data storage area. The program storage area may store an operating system, an application required by at least one function (for example, a voice playing function or an image playing function), and the like. The data storage area may store data (for example, audio data and video data) created during use of the electronic device 100, and the like. In addition, the memory 120 may include a high-speed random access memory, and may further include a non-volatile memory, for example, at least one magnetic disk storage device, a flash memory device, a universal flash storage (universal flash storage, UFS), and the like.

The communication module 130 may provide a wireless communication solution applied to the electronic device 100. The antenna 131 of the electronic device 100 is coupled to the communication module 130, so that the electronic device 100 can communicate with a network and another device by using a wireless communication technology. The wireless communication technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time division code division multiple access (time-division code division multiple access, TD-SCDMA), long term evolution (long term evolution, LTE), a 5th generation (5^{th} generation, 5G) system or new radio (new radio, NR), a future 6th generation (6^{th} generation, 6G) system, a non-terrestrial network (non-terrestrial network, NTN) system such as an inter-satellite communication system or a satellite communication system, a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, and the like. A satellite communication system includes a satellite base station and a terminal device. The satellite base station provides a communication service for the terminal device. The satellite base station may also communicate with a base station. A satellite may serve as a base station, or may serve as a terminal device. The satellite may be an uncrewed aerial vehicle, a hot air balloon, a low earth orbit satellite, a medium earth orbit satellite, a high earth orbit satellite, or the like. Alternatively, the satellite may be a non-terrestrial base station, a non-terrestrial device, or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite-based augmentation system (satellite-based augmentation system, SBAS).

The communication module 130 may include at least one filter, a switch, a power amplifier, a low noise amplifier (low noise amplifier, LNA), and the like. The communication module 130 may receive an electromagnetic wave through the antenna 131, perform processing such as filtering and amplification on the received electromagnetic wave, and transfer the electromagnetic wave to a modem processor for demodulation. The communication module 130 may further amplify a signal modulated by the modem processor, and convert the signal into an electromagnetic wave for radiation through the antenna 131. In some embodiments, at least some functional modules of the communication module 130 may be disposed in the processor 110. In some embodiments, at least some functional modules of the communication module 130 may be disposed in a same device as at least some modules of the processor 110.

The elastic wave apparatus provided in embodiments of this application may be used in the communication module 130. For example, the communication module 130 may include a SAW filter or a BAW filter provided in embodiments of this application.

For example, the electronic device 100 may be a mobile phone (mobile phone), a tablet computer, a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a terminal in vehicle-to-everything (vehicle-to-everything, V2X), a wireless terminal in self-driving (self-driving), a wireless terminal in remote medical surgery (remote medical surgery), a wireless terminal in a smart grid (smart grid), a wireless terminal in transportation safety (transportation safety), a wireless terminal in a smart city (smart city), a wireless terminal in a smart home (smart home), a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a compute device or another processing device connected to a wireless modem, a wearable device, a terminal device in a 5G network, a terminal device in a future evolved public land mobile network (public land mobile network, PLMN), or the like. A specific form of the electronic device 100 is not limited in embodiments of this application.

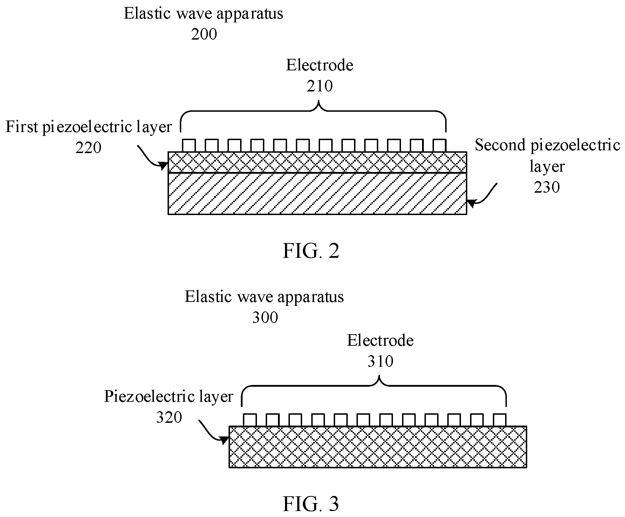

FIG. 2 is a diagram of a structure of an elastic wave apparatus according to an embodiment of this application. An elastic wave apparatus 200 shown in FIG. 2 includes an electrode 210, a first piezoelectric layer 220, and a second piezoelectric layer 230.

As shown in FIG. 2, the electrode 210 is disposed above the first piezoelectric layer 220, and the first piezoelectric layer 220 is disposed above the second piezoelectric layer 230.

A material of the electrode 210 may be an appropriate metal material, such as aluminum (Al), copper (Cu), platinum (Pt), gold (Au), silver (Ag), titanium (Ti), nickel (Ni), chromium (Cr), molybdenum (Mo), tungsten (W), or an alloy with any one of these metals as a main component. The electrode 210 may also have a structure in which a plurality of metal films formed of these metals or alloys are stacked.

Materials of the first piezoelectric layer 220 and the second piezoelectric layer 230 may be lithium tantalate crystals or lithium niobate crystals. For example, in some embodiments, the material of the first piezoelectric layer 220 may be a lithium tantalate single crystal. For another example, in some other embodiments, the material of the first piezoelectric layer 220 may be a lithium niobate single crystal. The material of the first piezoelectric layer 220 is the same as the material of the second piezoelectric layer 230. In other words, if the material of the first piezoelectric layer 220 is a lithium niobate single crystal, the material of the second piezoelectric layer 230 is also a lithium niobate single crystal.

An Euler angle of the first piezoelectric layer 220 is different from an Euler angle of the second piezoelectric layer 230.

The elastic wave apparatus provided in this embodiment of this application includes two piezoelectric layers having different Euler angles. The two piezoelectric layers having different Euler angles can suppress or reduce unnecessary high-order (high order) responses, allowing the elastic wave apparatus to have good electrical characteristics in a main vibration mode.

A conventional elastic wave apparatus includes only one piezoelectric layer. For example, FIG. 3 is a diagram of a conventional elastic wave apparatus. The elastic wave apparatus shown in FIG. 3 includes only an electrode 310 and one piezoelectric layer 320.

Compared with the elastic wave apparatus provided in this embodiment of this application, the conventional elastic wave apparatus typically generates an unnecessary high-order mode response.

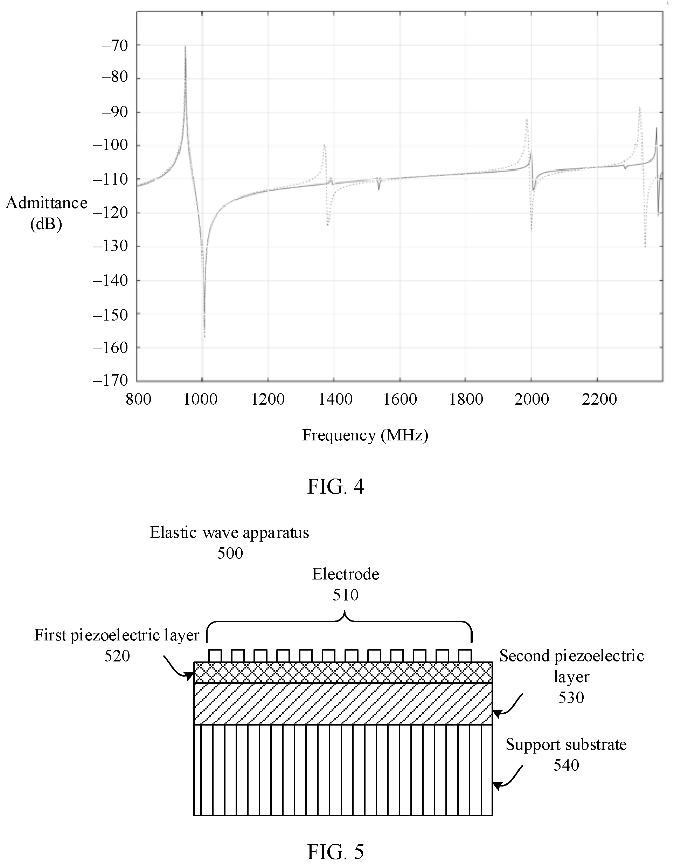

FIG. 4 shows characteristic curves of an elastic wave apparatus according to an embodiment of this application and a conventional elastic wave apparatus. A solid line in FIG. 4 represents a characteristic curve of the elastic wave apparatus 200, and a dashed line in FIG. 4 represents a characteristic curve of the elastic wave apparatus 300.

Refer to FIG. 4. At around 1400 megahertz (Mega Hertz, MHz), 2000 MHz, and 2300 MHz, a high-order mode response of the elastic wave apparatus 300 is significantly greater than a high-order mode response of the elastic wave apparatus 200. It can be seen that the elastic wave apparatus provided in this embodiment of this application can suppress high-order mode responses, allowing the elastic wave apparatus to have better electrical characteristics in the main vibration mode.

FIG. 5 shows another elastic wave apparatus according to an embodiment of this application. An elastic wave apparatus 500 shown in FIG. 5 includes an electrode 510, a first piezoelectric layer 520, a second piezoelectric layer 530, and a support substrate 540.

As shown in FIG. 5, the electrode 510 is disposed above the first piezoelectric layer 520, the first piezoelectric layer 520 is disposed above the second piezoelectric layer 530, and the second piezoelectric layer 530 is disposed above the support substrate 540.

A material of the electrode 510 may be an appropriate metal material, such as aluminum (Al), copper (Cu), platinum (Pt), gold (Au), silver (Ag), titanium (Ti), nickel (Ni), chromium (Cr), molybdenum (Mo), tungsten (W), or an alloy with any one of these metals as a main component. The electrode 510 may also have a structure in which a plurality of metal films formed of these metals or alloys are stacked.

Materials of the first piezoelectric layer 520 and the second piezoelectric layer 530 may be lithium tantalate crystals or lithium niobate crystals. For example, in some embodiments, the material of the first piezoelectric layer 520 may be a lithium tantalate single crystal. For another example, in some other embodiments, the material of the first piezoelectric layer 520 may be a lithium niobate single crystal. The material of the first piezoelectric layer 520 is the same as the material of the second piezoelectric layer 530. In other words, if the material of the first piezoelectric layer 520 is a lithium niobate single crystal, the material of the second piezoelectric layer 530 is also a lithium niobate single crystal.

An Euler angle of the first piezoelectric layer 520 is different from an Euler angle of the second piezoelectric layer 530.

A material of the support substrate 540 may be silicon, aluminum nitride, quartz, sapphire, spinel, or the like.

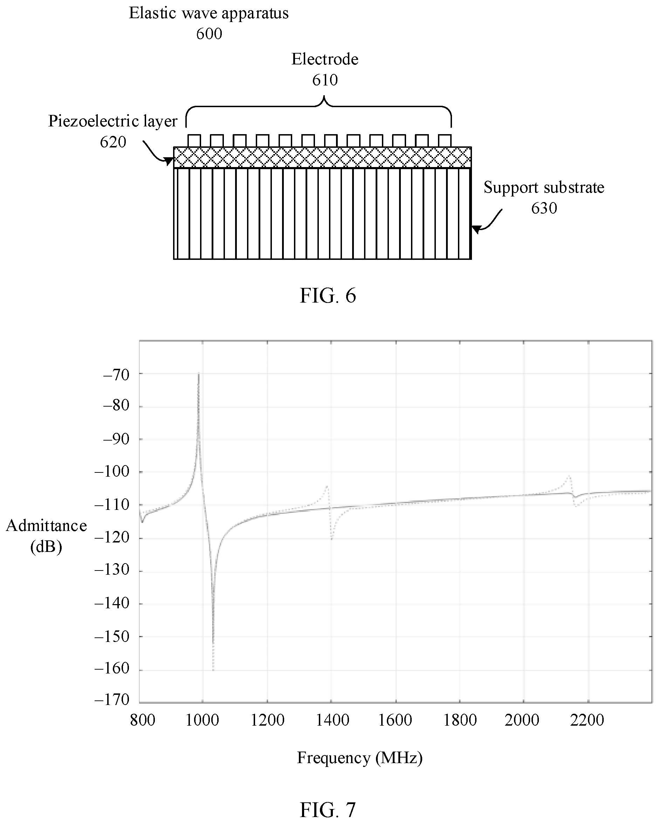

FIG. 6 is a diagram of a conventional elastic wave apparatus. The elastic wave apparatus shown in FIG. 6 includes only an electrode 610, one piezoelectric layer 620, and a support substrate 630.

FIG. 7 shows characteristic curves of an elastic wave apparatus according to an embodiment of this application and a conventional elastic wave apparatus. A solid line in FIG. 7 represents a characteristic curve of the elastic wave apparatus 500, and a dashed line in FIG. 7 represents a characteristic curve of the elastic wave apparatus 600.

Refer to FIG. 7. At around 1400 megahertz (Mega Hertz, MHz) and 2100 MHz, a high-order mode response of the elastic wave apparatus 600 is significantly greater than a high-order mode response of the elastic wave apparatus 500. It can be seen that the elastic wave apparatus provided in this embodiment of this application can suppress high-order mode responses, allowing the elastic wave apparatus to have better electrical characteristics in higher-order modes.

In some embodiments, one or more functional layers may be further disposed between the second piezoelectric layer and the support substrate. For example, in some embodiments, a temperature compensation layer and/or an intermediate dielectric layer may be disposed between the second piezoelectric layer and the support substrate.

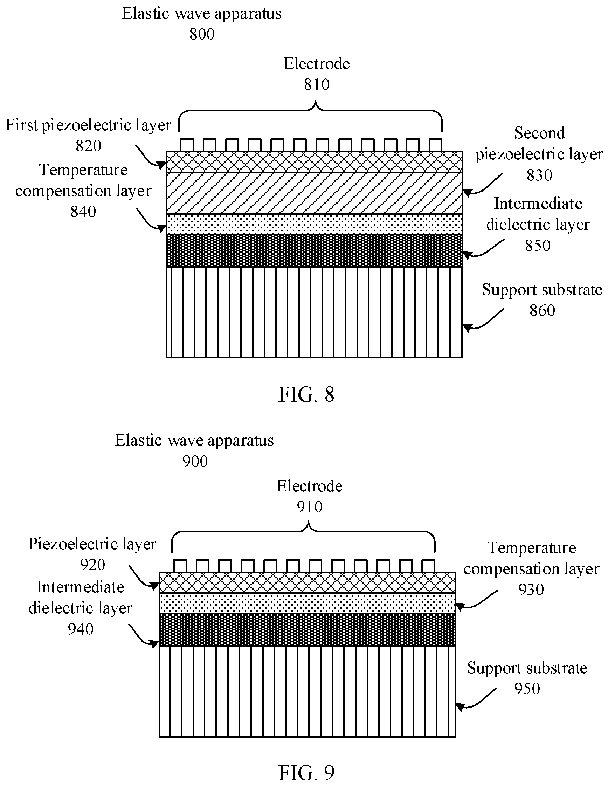

FIG. 8 shows still another elastic wave apparatus according to an embodiment of this application. An elastic wave apparatus 800 shown in FIG. 8 includes an electrode 810, a first piezoelectric layer 820, a second piezoelectric layer 830, a temperature compensation layer 840, an intermediate dielectric layer 850, and a support substrate 860.

As shown in FIG. 8, the electrode 810 is disposed above the first piezoelectric layer 820, the first piezoelectric layer 820 is disposed above the second piezoelectric layer 830, and the second piezoelectric layer 830 is disposed above the support substrate 840.

A material of the electrode 810 may be an appropriate metal material, such as aluminum (Al), copper (Cu), platinum (Pt), gold (Au), silver (Ag), titanium (Ti), nickel (Ni), chromium (Cr), molybdenum (Mo), tungsten (W), or an alloy with any one of these metals as a main component. The electrode 810 may also have a structure in which a plurality of metal films formed of these metals or alloys are stacked.

Materials of the first piezoelectric layer 820 and the second piezoelectric layer 830 may be lithium tantalate crystals or lithium niobate crystals. For example, in some embodiments, the material of the first piezoelectric layer 820 may be a lithium tantalate single crystal. For another example, in some other embodiments, the material of the first piezoelectric layer 820 may be a lithium niobate single crystal. The material of the first piezoelectric layer 820 is the same as the material of the second piezoelectric layer 830. In other words, if the material of the first piezoelectric layer 820 is a lithium niobate single crystal, the material of the second piezoelectric layer 830 is also a lithium niobate single crystal.

An Euler angle of the first piezoelectric layer 820 is different from an Euler angle of the second piezoelectric layer 830.

A material of the temperature compensation (temperature compensated) layer 840 (which may also be referred to as a temperature compensation thin film) may be silicon oxide.

A material of the intermediate dielectric layer 850 may be polycrystalline silicon.

A material of the support substrate 860 may be silicon, aluminum nitride, quartz, sapphire, spinel, or the like.

FIG. 9 is a diagram of a conventional elastic wave apparatus. The elastic wave apparatus shown in FIG. 9 includes only an electrode 910, a piezoelectric layer 920, a temperature compensation layer 930, an intermediate dielectric layer 940, and a support substrate 950.

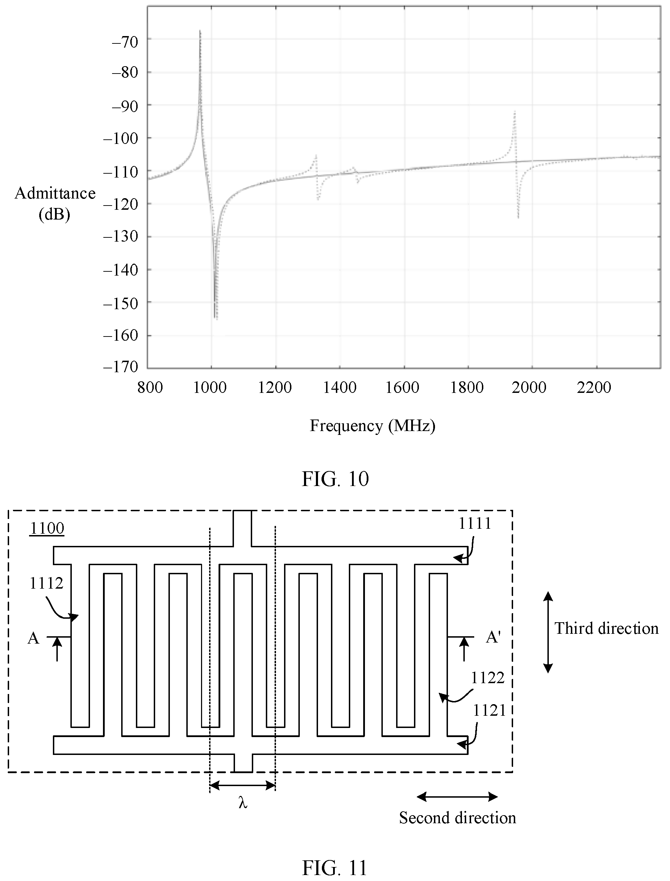

FIG. 10 shows characteristic curves of an elastic wave apparatus according to an embodiment of this application and a conventional elastic wave apparatus. A solid line in FIG. 10 represents a characteristic curve of the elastic wave apparatus 800, and a dashed line in FIG. 10 represents a characteristic curve of the elastic wave apparatus 900.

Refer to FIG. 10. At around 1300 MHz and 2000 MHz, a high-order mode response of the elastic wave apparatus 900 is significantly greater than a high-order mode response of the elastic wave apparatus 800. In particular, at around 2000 MHz, a response of the elastic wave apparatus 800 has been substantially eliminated. It can be seen that the elastic wave apparatus provided in this embodiment of this application can suppress high-order mode responses, allowing the elastic wave apparatus to have better electrical characteristics in higher-order modes.

In addition, a temperature compensation layer is introduced into the elastic wave apparatus 800 in FIG. 8. A sign of a temperature coefficient of the temperature compensation layer is opposite to a sign of a temperature coefficient of the first piezoelectric layer and a sign of a temperature coefficient of the second piezoelectric layer. In this way, a frequency deviation caused by a temperature change can be reduced.

An electrode (for example, the electrode 210, the electrode 510, or the electrode 810) in the elastic wave apparatuses provided in embodiments of this application is configured to generate an elastic wave with a wavelength λ. The elastic wave may be a Rayleigh wave (Rayleigh waves), a Lamb wave (Lamb waves), a shear wave (shear horizon waves, SH waves), or the like.

In some embodiments, the wavelength λ may be determined by an electrode finger period of the electrode. A SAW filter is used as an example. FIG. 11 is a diagram of an electrode of a SAW filter. The electrode in the SAW filter may also be referred to as an interdigitated (interdigitated, IDT) electrode. As shown in FIG. 11, an IDT electrode 1100 includes a first busbar 1111, a second busbar 1121, a plurality of first electrode fingers 1112, and a plurality of second electrode fingers 1122. The IDT electrode 1100 may be disposed on an upper surface of a first piezoelectric layer (for example, the first piezoelectric layer 220, the first piezoelectric layer 520, or the first piezoelectric layer 820).

The first busbar 1111 is formed as an elongated strip extending in a second direction, and is electrically connected to the plurality of first electrode fingers 1112. The second busbar 1121 is formed as an elongated strip extending in the second direction, and is electrically connected to the plurality of second electrode fingers 1122. The second direction is a direction orthogonal to a first direction.

The plurality of first electrode fingers 1112 are arranged and configured relative to each other in the second direction. Each first electrode finger 1112 is formed as an elongated strip extending in a third direction. The plurality of first electrode fingers 1112 are configured in parallel in a mutually opposite state in the second direction. The plurality of second electrode fingers 1122 are arranged and configured relative to each other in the second direction. Each second electrode finger 1122 is formed as an elongated strip extending in the third direction. The plurality of second electrode fingers 1122 are configured in parallel in a mutually opposite state in the second direction. The plurality of first electrode fingers 1112 and the plurality of second electrode fingers 1122 are alternately arranged and configured. The third direction is a direction that is orthogonal to both the first direction and the second direction.

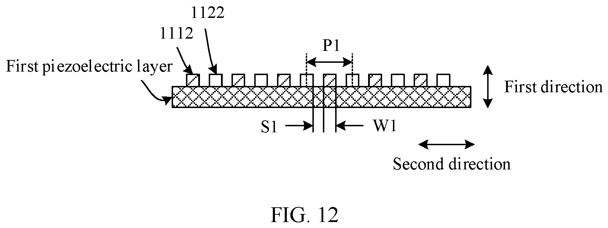

An electrode finger period of the IDT electrode 1100 is a distance between corresponding edges of a first electrode finger 1112 and a second electrode finger 1122 that are adjacent. As shown in FIG. 12, the electrode finger period of the IDT electrode 1100 is defined as a sum (W1+S1) of a width W1 of the first electrode finger 1112 and the second electrode finger 1122 and a spacing width S1 between an adjacent first electrode finger 1112 and second electrode finger 1122. In the IDT electrode 1100, a value obtained by dividing a width W1 of an electrode finger by the electrode finger period, that is, a duty cycle, is defined by W1/(W1+S1). The duty cycle is, for example, 0.5. A wavelength λ of an elastic wave specified by the electrode finger period of the IDT electrode 1100 is defined by a repetition period P1 of the plurality of first electrode fingers 1112 and the plurality of second electrode fingers 1122.

The elastic wave apparatuses provided in embodiments of this application include two piezoelectric layers, that is, a first piezoelectric layer and a second piezoelectric layer. The first piezoelectric layer is disposed above the second piezoelectric layer. Therefore, in some cases, the first piezoelectric layer may also be referred to as an upper piezoelectric layer, and the second piezoelectric layer may also be referred to as a lower piezoelectric layer.

As described above, in embodiments of this application, thicknesses of the first piezoelectric layer and the second piezoelectric layer (for example, the first piezoelectric layer 220 and the second piezoelectric layer 230, the first piezoelectric layer 520 and the second piezoelectric layer 530, or the first piezoelectric layer 820 and the second piezoelectric layer 830) are different. In some embodiments, the thickness of the first piezoelectric layer is less than the thickness of the second piezoelectric layer. For example, a ratio of the thickness of the first piezoelectric layer to the thickness of the second piezoelectric layer may be 1:2. For another example, a ratio of the thickness of the first piezoelectric layer to the thickness of the second piezoelectric layer may be approximately 1:2, for example, may be 1.1:2, 1.2:2, 1.05:2, or 1.3:2.

In some embodiments, a sum of the thickness of the first piezoelectric layer and the thickness of the second piezoelectric layer is less than or equal to 0.4λ. For example, in some embodiments, the thickness of the first piezoelectric layer may be 0.1λ, and the thickness of the second piezoelectric layer may be 0.2λ.

As described above, in embodiments of this application, Euler angles of the first piezoelectric layer and the second piezoelectric layer (for example, the first piezoelectric layer 220 and the second piezoelectric layer 230, the first piezoelectric layer 520 and the second piezoelectric layer 530, or the first piezoelectric layer 820 and the second piezoelectric layer 830) are different. It is assumed that an Euler angle of the first piezoelectric layer is represented as (φ, θ, ψ), and an Euler angle of the second piezoelectric layer may be (φ, θ+180±60, ψ+180±5). For example, if the Euler angle of the first piezoelectric layer is (0, -48, 0), the Euler angle of the second piezoelectric layer may be (0, 142, 180).

As described above, in embodiments of this application, signs of piezoelectric constant tensors of the first piezoelectric layer and the second piezoelectric layer (for example, the first piezoelectric layer 220 and the second piezoelectric layer 230, the first piezoelectric layer 520 and the second piezoelectric layer 530, or the first piezoelectric layer 820 and the second piezoelectric layer 830) are different. For example, in some embodiments, the piezoelectric constant tensor may be represented as e15, e24, e31, e32, e33, or the like. If a sign of a piezoelectric constant tensor of the first piezoelectric layer is positive, a sign of a piezoelectric constant tensor of the second piezoelectric layer is negative; or if a sign of a piezoelectric constant tensor of the first piezoelectric layer is negative, a sign of a piezoelectric constant tensor of the first piezoelectric layer is positive.

In some embodiments, a thickness of an electrode (for example, the electrode 210, the electrode 510, or the electrode 810) in the elastic wave apparatuses provided in embodiments of this application may be greater than or equal to 0.03λ and less than or equal to 0.12λ. For example, in some embodiments, the thickness of the electrode may be 0.08λ, 0.10λ, 0.12λ, or the like.

In some embodiments, when the elastic wave apparatus includes a support substrate (for example, the elastic wave apparatus 500 or the elastic wave apparatus 800), an elastic wave velocity of the support substrate is greater than an elastic wave velocity of the first piezoelectric layer and an elastic wave velocity of the second piezoelectric layer.

In some embodiments, the elastic wave velocity of the support substrate is less than 6500 m/s.

In some embodiments, when the elastic wave apparatus includes a temperature compensation layer (for example, the elastic wave apparatus 800), an elastic wave velocity of the temperature compensation layer is less than the elastic wave velocity of the first piezoelectric layer and the elastic wave velocity of the second piezoelectric layer.

Table 1 and Table 2 show piezoelectric tensors of two piezoelectric layers included in an elastic wave apparatus according to an embodiment of this application.

**Table 1**

| | | | | | |
|---|---|---|---|---|---|
| 0.0000 | 0.0000 | 0.0000 | 0.0000 | 0.3843 | -3.2065 |
| -1.0811 | -1.8282 | 1.9655 | 1.1474 | 0.0000 | 0.0000 |
| -1.5295 | -0.7663 | 3.1455 | -0.1599 | 0.0000 | 0.0000 |

**Table 2**

| | | | | | |
|---|---|---|---|---|---|
| 0.0000 | 0.0000 | 0.0000 | 0.0000 | -0.3843 | -3.2065 |
| -1.0811 | -1.8282 | 1.9655 | -1.1474 | 0.0000 | 0.0000 |
| 1.5295 | 0.7663 | -3.1455 | -0.1599 | 0.0000 | 0.0000 |

Table 1 shows a piezoelectric tensor of the first piezoelectric layer (assuming that the Euler angle of the first piezoelectric layer is (0, -48, 0)). Table 2 shows a piezoelectric tensor of the second piezoelectric layer (assuming that the Euler angle of the second piezoelectric layer is (0, 132, 180)). It can be seen that both the piezoelectric tensor of the first piezoelectric layer and the piezoelectric tensor of the second piezoelectric layer are represented by a 3×6 matrix. The 3×6 matrix of the first piezoelectric layer is in a one-to-one correspondence with the 3×6 matrix of the second piezoelectric layer. Absolute values of corresponding elements in the matrices are the same, but signs of some elements are opposite. For example, an element in a third row of a first column in Table 1 is -1.5295, and an element in a third row of a first column in Table 2 is 1.5295.

Embodiments of this application further provide a circuit. The circuit may include one or more elastic wave apparatuses provided in embodiments of this application. For example, the circuit includes one or more elastic wave apparatuses 200. For another example, the circuit includes one or more elastic wave apparatuses 500. For another example, the circuit includes one or more elastic wave apparatuses 800. The circuit may be used in an electronic device. For example, it is assumed that the electronic device is the electronic device 100 shown in FIG. 1. In this case, the circuit may be located in the communication module 130 in the electronic device 100.

Embodiments of this application further provide an electronic device. The electronic device includes the foregoing circuit. The electronic device may be the electronic device 100 shown in FIG. 1. Alternatively, the electronic device may be a network device, an internet of things device, an electric vehicle, a hybrid vehicle, an unmanned aerial vehicle, or the like.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments. Details are not described herein again.

In the several embodiments provided in this application, it should be understood that the disclosed system, apparatus, and method may be implemented in other manners. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented by using some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in a form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (Read-Only Memory, ROM), a random access memory (Random Access Memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An elastic wave apparatus, comprising an electrode, a first piezoelectric layer, and a second piezoelectric layer, wherein
the electrode is disposed on the first piezoelectric layer, and the electrode is configured to generate an elastic wave with a wavelength λ; and
the first piezoelectric layer is disposed above the second piezoelectric layer, wherein an Euler angle of the first piezoelectric layer is different from an Euler angle of the second piezoelectric layer, a material of the first piezoelectric layer is the same as a material of the second piezoelectric layer, and the material of the first piezoelectric layer and the material of the second piezoelectric layer are lithium tantalate or lithium niobate.

2. The elastic wave apparatus according to claim 1, wherein a thickness of the first piezoelectric layer is less than a thickness of the second piezoelectric layer.

3. The elastic wave apparatus according to claim 2, wherein a ratio of the thickness of the first piezoelectric layer to the thickness of the second piezoelectric layer is 1:2.

4. The elastic wave apparatus according to any one of claims 1 to 3, wherein a sum of the thickness of the first piezoelectric layer and the thickness of the second piezoelectric layer is less than or equal to 0.4λ.

5. The elastic wave apparatus according to any one of claims 1 to 4, wherein the Euler angle of the first piezoelectric layer is (φ, θ, ψ), and the Euler angle of the second piezoelectric layer is (φ, θ+180±60, ψ+180±5).

6. The elastic wave apparatus according to any one of claims 1 to 5, wherein a sign of a piezoelectric constant tensor of the first piezoelectric layer is different from a sign of a piezoelectric constant tensor of the second piezoelectric layer.

7. The elastic wave apparatus according to any one of claims 1 to 6, wherein a thickness of the electrode is greater than or equal to 0.03λ and less than or equal to 0.12λ.

8. The elastic wave apparatus according to any one of claims 1 to 7, wherein the elastic wave apparatus further comprises a support substrate located below the second piezoelectric layer, and an elastic wave velocity of the support substrate is greater than an elastic wave velocity of the first piezoelectric layer and an elastic wave velocity of the second piezoelectric layer.

9. The elastic wave apparatus according to claim 8, wherein the elastic wave apparatus further comprises a temperature compensation layer, the temperature compensation layer is located between the second piezoelectric layer and the support substrate, and a sign of a temperature coefficient of the temperature compensation layer is opposite to a sign of a temperature coefficient of the first piezoelectric layer and a sign of a temperature coefficient of the second piezoelectric layer.

10. The elastic wave apparatus according to claim 9, wherein an elastic wave velocity of the temperature compensation layer is less than the elastic wave velocity of the first piezoelectric layer and the elastic wave velocity of the second piezoelectric layer.

11. The elastic wave apparatus according to claim 9 or 10, wherein the elastic wave further comprises an intermediate dielectric layer, and the intermediate dielectric layer is located between the temperature compensation layer and the support substrate.

12. A circuit, wherein the circuit comprises the elastic wave apparatus according to any one of claims 1 to 11.

13. A communication apparatus, wherein the communication apparatus comprises the circuit according to claim 12.
